# EUROPÄISCHE PATENTANMELDUNG

(11) **EP 1 219 966 A2**
(43) Veröffentlichungstag der Anmeldung: **03.07.2002**
(21) Anmeldenummer: 01125927.2
(22) Anmeldetag: 31.10.2001
(51) Int. Cl.: G01R 19/00

(54) **Einrichtung zur Messung kleiner Spannungssignale**

(30) Priorität: 04.11.2000 DE 10054754
(71) Anmelder: ABB PATENT GmbH, 68526 Ladenburg (DE)
(72) Erfinder: Keese, Dieter, 37194 Wahlsburg (DE); Appel, Eggert Jun., 37127 Dransfeld (DE)
(74) Vertreter: Schmidt, Karl Michael, Dipl.-Phys.

(57) **Zusammenfassung**

Die Erfindung betrifft eine Einrichtung zur Messung kleiner hochohmiger Signale an Meßeinrichtungen, bei welcher das Meßsignal in einem Operationsverstärker verstärkt wird, gemäß Oberbegriff des Patentanspruches 1. Um hierbei die parasitären Kapazitäten innerhalb des Operationsverstärkers, auf jeden Operationsverstärker individuell anpaßbar zu kompensieren, ist erfindungsgemäß vorgeschlagen, daß eine gleichphasige Rückkopplung des Ausgangssignals des Operationsverstärkers (OP) über die parasitären Kapazitäten (Cp1,...,Cp6) des Operationsverstärkers (OP) auf dessen Eingang (E) mittels eines Potentiometers (P1) erfolgt.

## Beschreibung

Die Erfindung betrifft eine Einrichtung zur Messung kleiner hochohmiger Signale an Meßeinrichtungen, bei welcher das Meßsignal in einem Operationsverstärker verstärkt wird, gemäß Oberbegriff des Patentanspruches 1.

Operationsverstärker sind gängige elektronische Mittel zur Verstärkung von Meßsignalen in Meßeinrichtungen. In dem Fall, daß die Signale an Spannungsquellen mit Innenwiderständen größer oder gleich 10⁹ Ohm benutzt werden, haben parasitäre Kapazitäten in den verwendeten Operationsverstärkern einen negativen Einfluß auf den eigentlichen Verlauf des dynamischen Meßsignals. Grundsätzlich haben Operationsverstärker aufgrund ihrer Physis immer parasitäre Kapazitäten, die jedoch bei solch extrem hochohmigen Signalen negativ auf das Meßsignal einwirken.

Grundsätzlich lassen sich diese parasitären Kapazitäten durch eine passive Schaltung nicht kompensieren, da die besagten parasitären Kapazitäten aufgrund einer Vielzahl von Einflüssen nicht genau bestimmbar sind. Grundsätzlich sind Operationsverstärker integrierte Schaltkreise, die als entsprechende Topographie auf einem Halbleitersubstrat aufgebaut sind. Stromführende Sektionen, die benachbart sind, bewirken immer und grundsätzlich eine Kapazität, die bei niederohmigen Signalen natürlich keine Rolle spielen, jedoch bei hochohmigen Signalen als Störeinfluß deutlich hervortritt.

Durch diese parasitären Kapazitäten innerhalb des Operationsverstärkers, aber auch innerhalb der unmittelbaren Beschaltung des Operationsverstärkers, entstehen Amplituden- und Phasenunterschiede zwischen Eingangs- und Ausgangssignal, die zu erheblichen Meßfehlern führen können.

Demnach scheiden bei der Verstärkung besagter hochohmiger Signale passive Schaltungen oder fest eingestellte Kompensationsgrößen aus, da sie immer nur einen ideellen Zustand kompensieren, der jedoch bei einem unterschiedlichen dynamischen Meßsignal nicht erreicht wird. Allenfalls könnten mit passiven Kompensationsschaltungen aus dem Stand der Technik, bezogen auf einen Mittelwert kompensiert werden, der jedoch nicht immer, und vor allem nicht für jeden Operationsverstärker gleich wäre. Somit wäre eine solche Kompensationsschaltung passiver Art wenig sinnvoll, da im oben beschriebenen Meßfall schon zwischen zwei Geräten gleicher Bauart Meßfehler, und damit unterschiedliche ausgewertete Meßsignale bei gleichem Signaleingang erzeugt würden.

Der Erfindung liegt somit die Aufgabe zugrunde, diesen Mangel zu beseitigen, und die parasitären Kapazitäten innerhalb des Operationsverstärkers, auf jeden Operationsverstärker individuell anpaßbar zu kompensieren.

Die gestellte Aufgabe ist bei einer Einrichtung der gattungsgemäßen Art erfindungsgemäß durch die kennzeichnenden Merkmale des Patentanspruches 1 gelöst.

Weitere vorteilhafte Ausgestaltungen der erfindungsgemäßen Einrichtungen sind in den abhängigen Ansprüchen angegeben.

Im Hinblick auf eine entsprechende Verwendung der erfindungsgemäßen Einrichtung ist eine ebenso erfindungsgemäße Verwendung für eine induktive oder kapazitive Durchflußmeßeinrichtung in Anspruch 6 angegeben.

Kern der Erfindung ist hierbei, daß eine gleichphasige Rückkopplung des Ausgangssignals des Operationsverstärkers über die parasitären Kapazitäten des Operationsverstärkers auf dessen Eingang mittels einem Potentiometer erfolgt. Das Potentiometer ist nunmehr einstellbar und kann auf die entsprechenden parasitären Kapazitäten eingestellt werden.

Der Operationsverstärker weist zum einen zwei Pins für den Eingang des Meßsignals auf, und einen Ausgang. Überdies verfügt er über Steuerein- und -ausgänge, die in der Regel als VCC (+) und VCC (-) bezeichnet sind. Darüber hinaus sind weitere Steuereingänge möglich bzw. vorgesehen, beispielsweise für die Steuerung des Frequenzganges. Zwischen diesen Steuereingängen und dem Eingangssignal besteht keine direkt implementierte galvanische Verbindung, sondern es besteht eine faktische parasitäre kapazitive Kopplung zwischen beiden, nämlich zwischen Steuereingängen und Meßsignaleingang. Diese Kapazitäten sind somit nicht gewollt implementiert, sondern entstehen ungewollt, sind aber schaltungstechnisch als kapazitive Verbindung zwischen beiden zu werten. Bei der vorliegenden Erfindung wird nunmehr ein Potentiometer verwendet, das heißt ein einstellbarer Widerstand, der zwischen dem Signalausgang und der Masse, also dem Bezugspotentials des Operationsverstärkers angeordnet ist, und der Mittelabgriff dieses Potentiometers wird nun galvanisch auf die oder einen der Steuereingänge des Operationsverstärkers gelegt, der wiederum über die besagte parasitäre Kapazität an den Eingang des Operationsverstärkers gekoppelt ist. Über den so einstellbaren Wert am Potentiometer ist die besagte parasitäre kapazitive Rückkopplung auf den Eingang kompensierbar. Hierbei kann durch Wahl der Einstellung des Potentiometers genau auf die individuell vorhandene parasitäre Kapazität hin eingestellt werden.

In weiterer vorteilhafter Ausgestaltung ist vorgesehen, daß die Rückkopplung des Ausgangssignals auf das Eingangssignal über das Substrat und/oder das Gehäuse des OPs erfolgt. Auf diese Weise hat man ebenfalls eine direkte Verbindung über die besagten parasitären Kapazitäten.

In weiterer vorteilhafter Ausgestaltung ist angegeben, daß die besagte beschriebene Einrichtung als Schaltungsteil in eine nicht invertierende Verstärkerstufe integriert ist, dessen Teil die besagte schaltungstechnische Einrichtung ist.

Besonders vorteilhaft ist die Verwendung der besagten erfindungsgemäßen Einrichtung bei einer induktiven oder kapazitiven Durchflußmeßeinrichtung für Flüssigkeiten durch ein Meßrohr. Bei einer Einrichtung dieser Art entstehen extrem hochohmige kleine Spannungssignale, die jedoch grundsätzlich eine hohe Reproduzierbarkeit auf den darüber geschlossenen Durchfluß mit dem besagten flüssigen Meßmedium hat. Es bedarf also einer geeignet guten und reproduzierbaren Auswertung, wobei aufgrund der Hochohmigkeit des Meßsignals bei der besagten Durchflußmeßtechnik der erfindungsgemäßen Verfahrensweise eine erhebliche Rolle spielt. Mit einer Einrichtung dieser Art können diese einfach und reproduzierbar und vor allen Dingen für jeden individuellen Meßverstärker eingestellt werden, so daß auch in der Serienfertigung Geräte mit gleichwertiger reproduzierbarer Anzeige entstehen.

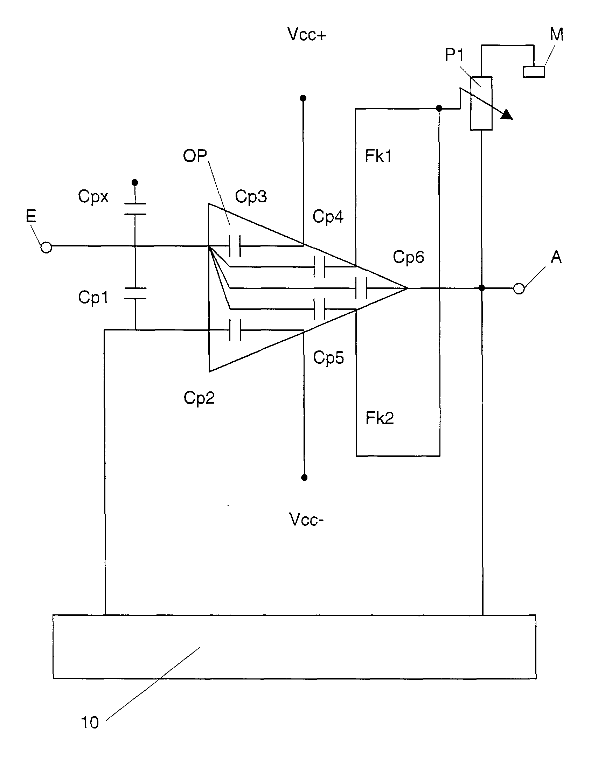

Die Erfindung ist in der Zeichnung dargestellt und nachfolgend näher beschrieben.

Die Zeichnung stellt einen Teilausschnitt einer gesamten nicht invertierenden Verstärkerstufe dar. Hierbei ist ein Operationsverstärker OP dargestellt, an dessen Positiveingang E das Meßsignal ankommt. Der Negativeingang ist mit der übrigen Schaltung 10 verbunden. Weitere parasitäre Kapazitäten CPX entstehen somit im Meßsignalpfad gegenüber benachbarten Pins und Potentialen innerhalb der Schaltung. Eine weitere parasitäre Kapazität entsteht zwischen dem positiven und negativen Eingang des Operationsverstärkers, in diesem Falle als CP 1 dargestellt. Zwischen Eingang und Ausgang des Operationsverstärkers ist hier neben der letztendlich verstärkenden Verbindung auch wiederum eine Kapazität CP 6 darstellbar. Weitere parasitäre Kapazitäten entstehen zwischen den Steuereingängen VCC+ und VCC- und dem Eingang des Operationsverstärkers sowie zwischen den zusätzlichen Steuereingängen FK 1 und FK 2 des Operationsverstärkers und dem Eingang E des Operationsverstärkers. Die besagten Steuereingänge FK 1 und FK 2 sind hierbei nur beispielhaft als Steuereingänge bezeichnet, es kann auch bei den Steuereingängen VCC+ und VCC- bleiben und die besagten Eingänge FK 1 und FK 2 sind keine Steuereingänge, sondern der untere stellt den Gehäuseanschluß des Operationsverstärkers, und der andere den Substratanschluß dar.

In erfindungsgemäßer Weise ist nun ein Potentiometer zwischen dem Ausgangssignal des Operationsverstärkers und der Masse oder Bezugspotential des Operationsverstärkers schaltungstechnisch eingebracht. Physisch ist nun der Mittelabgriff des Potentiometers, bei Vorhandensein der Frequenzsteuereingänge FK 1 und FK 2 mit den selben galvanisch verbunden, und im anderen Falle, daß die besagten Frequenzsteuereingänge nicht existieren, ist der besagte Mittelabgriff des Potentiometers galvanisch mit dem Substratanschluß und mit dem Gehäuseanschluß des Operationsverstärkers verbunden. Somit wird direkt auf die hier dargestellten parasitären Kapazitäten CP 4 und CP 5 eingewirkt, so daß über die besagten parasitären Kapazitäten CP 4 und CP 5 eine kompensierende Rückkopplung wiederum auf den Eingang des Operationsverstärkers erfolgt, und die besagten parasitären Kapazitäten auf diese Weise kompensiert werden.

Wie gesagt, ist es wichtig, in diesem Falle zwei Kompensationsfälle zu unterscheiden, nämlich die Möglichkeit über die Steuereingänge, FK 1 und FK 2, zu kompensieren, denkbar wäre auch eine Kompensation über die Steuereingänge VCC+ und VCC-, und zum Zweiten nicht direkt auf die Steuereingänge einzuwirken, sondern die Kompensation über den Substrat- und den Gehäuseanschluß des Operationsverstärkers erfolgen zu lassen. In beiden genannten Möglichkeiten oder Fällen ist es wichtig, daß die Kompensation hierbei aktiv über einen einstellbaren realen Widerstand also ein Potentiometer erfolgt.

Im übrigen ist der hier als erfindungsgemäß dargestellte obere Teil der Schaltung wiederum Bestandteil bzw. integraler Bestandteil einer nicht invertierenden Verstärkerstufe, die im unteren Bildteil nur symbolisch dargestellt ist.

Vorteilhafterweise ist, wie oben bereits ausführlich dargestellt, die erfindungsgemäße Einrichtung von erheblichem Vorteil beim Einsatz in induktiven oder kapazitiven Durchflußmeßeinrichtungen. Da bei diesen Meßeinrichtungen höchstreproduzierbare durchflußabhängige Signale entstehen, die jedoch extrem hochohmig sind, bedarf es einer geeigneten Kompensation, um bei der Messung reproduzierbare Werte zu erhalten.

## Patentansprüche

1. Einrichtungen zur Messung kleiner hochohmiger Signale an Meßeinrichtungen, bei welcher das Meßsignal in einem Operationsverstärker verstärkt wird,
**dadurch gekennzeichnet,**
**daß** eine gleichphasige Rückkopplung des Ausgangssignals des Operationsverstärkers (OP) über die parasitären Kapazitäten (Cp1,...,Cp6) des Operationsverstärkers (OP) auf dessen Eingang (E) mittels eines Potentiometers (P1) erfolgt.

2. Einrichtungen nach Anspruch 1,
**dadurch gekennzeichnet,**
**daß** der Mittelabgriff des Potentiometers (P1), welches zwischen Signalausgang (A) und Masse (M) liegt, galvanisch auf die Steuereingänge (Fk1, Fk2) und/oder Substrat und Gehäuseanschluß des Operationsverstärkers (OP) gelegt ist.

3. Einrichtungen nach Anspruch 2,
**dadurch gekennzeichnet,**
**daß** die Verbindung zwischen Steuereingängen (Fk1, Fk2) und/oder Substratanschluß und Gehäuseanschluß und Signaleingang (E) über parasitäre Kapazitäten (Cp1,...,Cp6) darstellbar ist, über welche die besagte Rückkopplung des Ausgangssignals auf den Eingang (E) des Operationsverstärkers (OP) realisiert ist.

4. Einrichtungen nach einem der vorhergehenden Ansprüche,
**dadurch gekennzeichnet,**
**daß** die Rückkopplung auf den Signaleingang (E) über das Substrat und/oder das Gehäuse des Operationsverstärkers (OP) erfolgt.

5. Einrichtungen nach einem der vorhergehenden Ansprüche,
**dadurch gekennzeichnet,**
**daß** die besagte beschriebene Einrichtung als Schaltungsteil in eine nicht invertierende Verstärkerstufe integriert ist.

6. Induktive oder kapazitive Durchflußmeßeinrichtung für Flüssigkeiten durch ein Meßrohr, mit einer Einrichtung zur Messung kleiner Signale nach einem oder mehreren der vorhergehenden Ansprüche.
